# EUROPEAN PATENT SPECIFICATION

(11) **EP 0 390 600 B1**
(45) Date of publication and mention of the grant of the patent: **20.07.1994**
(21) Application number: 90303462.7
(22) Date of filing: 30.03.1990
(51) Int. Cl.: H03H 1/00

(54) **Filter apparatus**
Filtergerät
Appareil de filtrage

(30) Priority: 30.03.1989 JP 79941/89; 30.03.1989 JP 79942/89
(43) Date of publication of application: 03.10.1990
(73) Proprietor: SONY CORPORATION, Tokyo 141 (JP)
(72) Inventor: Takao, Nobutaka, c/o Patents Division, Shinagawa-ku, Tokyo 141 (JP); Yokoya, Satoshi, c/o Patents Division, Shinagawa-ku, Tokyo 141 (JP); Takagi, Kotaro, c/o Patents Division, Shinagawa-ku, Tokyo 141 (JP)
(74) Representative: Cotter, Ivan John

(56) References cited:
- EP-A- 0 214 492
- GB-A- 2 011 190
- PATENT ABSTRACTS OF JAPAN, vol. 7, no. 222 (E-201), 4th October 1983; & JP-A-58 114 503 (FUJITSU K.K.) 07-07-1983
- PATENT ABSTRACTS OF JAPAN, vol. 13, no. 92 (E-722), 3rd March 1989; & JP-A-63 269 596 (SEIKO EPSON CORP.) 07-11-1988
- PATENT ABSTRACTS OF JAPAN, vol. 5, no. 117 (E-067), 28th July 1981; & JP-A-56 057 343 (MATSUSHITA ELECTRIC IND. CO., LTD) 19-05-1981

## Description

This invention relates to filter apparatuses. More particularly, but not exclusively, the invention relates to filter apparatuses in which a filter, for example a bandpass filter, is mounted on a printed circuit board, the apparatus being suitable, for instance, for use in a communication system, such as a mobile telephone system.

In a duplex-type communication system, such as a mobile telephone system, a directional coupler or aerial (antenna) coupling device is generally utilised to transmit and/or receive radio waves via a single aerial (antenna). A device of this type is shown in Patent Abstracts of Japan, vol. 5, no. 117 (E-067), 28.07.81 and in the Japanese Patent JP-A-56 057 343.

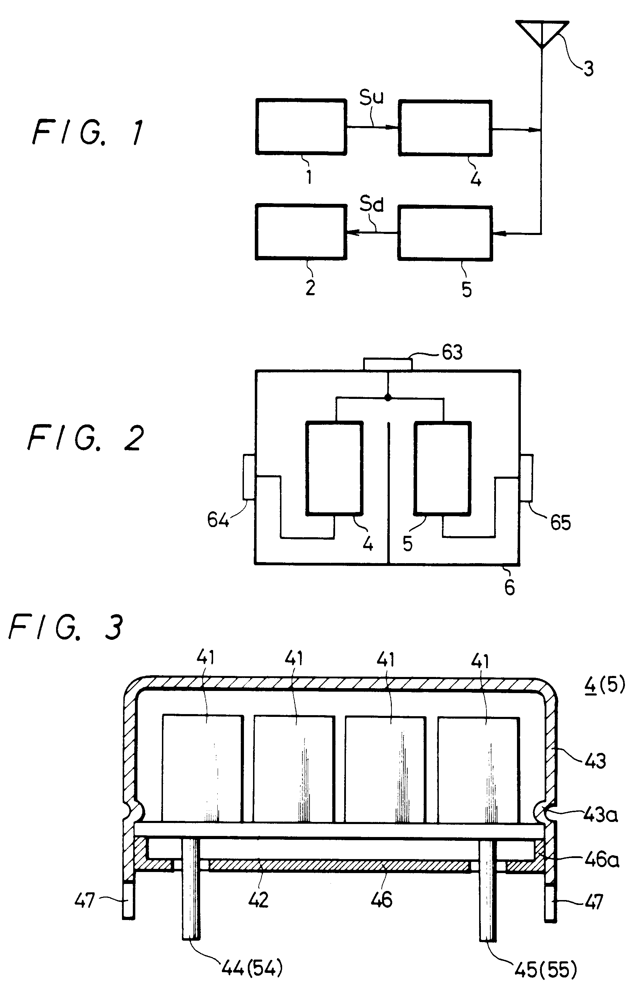

As shown in Figure 1 of the accompanying drawings, when a transmission signal Su of an up-channel is generated by a transmitting circuit 1, the signal Su is supplied to an aerial 3 through a transmission bandpass filter 4 whose pass band covers signals of all of a plurality of up-channels. Then, the signal supplied to the aerial 3 is suitably transmitted to a base station (not shown). A down-channel signal Sd is generated by the base station and is received by the aerial 3. The received signal Sd is supplied to a receiving circuit 2 through a reception bandpass filter 5 whose pass band covers signals of all of a plurality of down-channels.

In the mobile telephone system, the frequencies of the transmitted and received signals Su and Sd are in a high frequency range, for example 800 to 900 MHz, so that, as might be expected, leakage of the signals frequently occurs.

To solve the above-described signal leakage problem, the bandpass filters 4 and 5 may be accommodated in a common unitary shield casing 6 as shown in Figure 2 of the accompanying drawings. An output terminal of the bandpass filter 4 and an input terminal of the bandpass filter 5 are connected to a coaxial connector 63, an input terminal of the bandpass filter 4 is connected to a coaxial connector 64, and an output terminal of the bandpass filter 5 is connected to a coaxial connector 65. The input and output coaxial connectors 63, 64 and 65 are provided on different side surfaces of the shield casing 6, as shown in Figure 2. It is desired that such an isolation characteristic exist between the terminals connected to the coaxial connectors 63, 64, and 65 that a response outside of the pass band is less than -60 dB.

Thus, a directional coupler is formed by the bandpass filters 4 and 5 accommodated within the unitary shield casing 6. Nevertheless, this directional coupler formed as a single body has an unavoidable defect that it requires three separate coaxial connectors, namely the connectors 63, 64 and 65. Thus, the aerial apparatus is made expensive. Further, it is difficult to mount the aerial apparatus on a printed circuit board because the three coaxial connectors 63, 64, and 65 are located on different side surfaces of the shield casing 6.

According to a first aspect of the invention there is provided a filter apparatus which comprises a multi-layer printed circuit board and a filter mounted on the printed circuit board and having input and output terminals that extend through and protrude from the printed circuit board. The printed circuit board comprises insulating substrates and a connection conductive pattern is formed on an upper or inner surface of one substrate that faces or is in contact with the other substrate. Conductive layers are formed on outer surfaces of the respective substrates so that one conductive layer is positioned above or on one side of the connection conductive pattern and another is positioned below or on the other side of the connection conductive pattern. At least one of the input and output terminals of the filter is connected to the connective conductive pattern and the conductive layers are grounded, thereby shielding the connection conductive pattern.

According to a second aspect of the invention there is provided a filter apparatus which comprises a multi-layer printed circuit board and a filter mounted on the printed circuit board and having input and output terminals that extend through and protrude from the printed circuit board. The printed circuit board comprises insulating substrates and a connection conductive pattern is formed on an upper or inner surface of one substrate that faces or is in contact with the other substrate. Conductive layers are formed on outer surfaces of the respective substrates such that one conductive layer is positioned above or on one side of the connection conductive pattern and another is positioned below or on the other side of the connection conductive pattern. A plurality of through-hole conductive layers are formed through the conductive layers so as to connect the outer conductive layers and so as to encircle the connective conductive pattern, the conductive layers connected by the through-hole layers being grounded and the connection conductive pattern being shielded by the conductive layers and the through-hole layers.

Preferred embodiments of the invention described below provide a filter apparatus that: is mounted on a multi-layer printed circuit board and can eliminate or at least alleviate the above-noted defects of the prior art; have an improved shielding effect; enable filters and signal paths to be freely designated without or with reduced signal leakage; enables filters and signal paths to be positioned with greater freedom; and can be designed to avoid or at least reduce transmission and reflection losses.

The invention will now be further described, by way of illustrative and non-limiting example, with reference to the accompanying drawings, in which like reference numerals are used to identify the same or similar parts in the several figures, and in which:
Figure 1 is a block diagram showing an example of a previously proposed duplex type communication apparatus;
Figure 2 is a schematic diagram showing an example of filters accommodated within a single shield casing;
Figure 3 is an elevational view in cross-section of a filter of a filter apparatus according to a first embodiment of the invention;
Figure 4 is a perspective view of the filter of Figure 3;
Figure 5 is an elevational view in cross-section of the filter apparatus embodying the invention;
Figure 6 is a plan view showing a pattern of an upper substrate of a printed circuit board used in the embodiment of Figure 5;
Figure 7 is a plan view showing an upper surface pattern of a lower substrate of the printed circuit board used in the embodiment of Figure 5;
Figure 8 is a bottom plan view showing a lower surface pattern of the lower substrate of the printed circuit board used in the embodiment of Figure 5;
Figure 9 is a plan view showing a lower surface pattern of a lower substrate of a printed circuit board used in a second embodiment of the invention; and
Figure 10 is a plan view showing the overall arrangement of a filter apparatus embodying the invention.

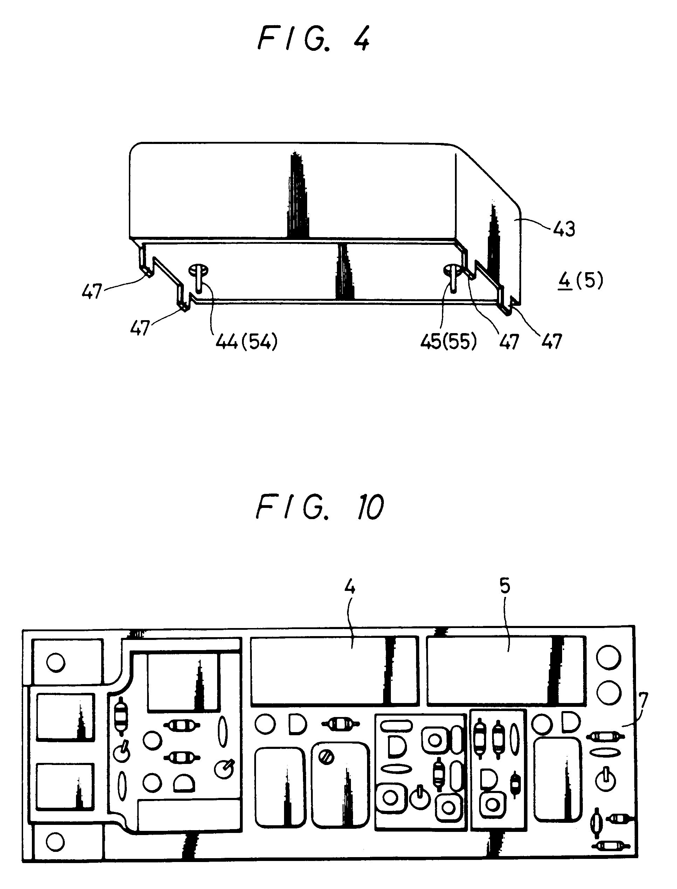

Referring to the drawings in detail, and initially to Figures 3 to 6 and Figures 8 to 10, a first filter apparatus embodying the invention will be described. As shown in Figures 3 and 4, the transmission bandpass filter 4 includes a plurality of resonant circuits 41 mounted on a printed circuit board (PCB) 42. The plurality of resonant circuits 41 mounted on the PCB 42 are accommodated within a rectangular shield casing 43. An input terminal 44 and an output terminal 45 are connected to a predetermined pattern on the PCB 42 and both terminals protrude, in the same direction, from a bottom shield plate 46 of the shield casing 43. The shield casing 43 includes leg portions or filter tabs 47 for soldering to the final assembly and completing the shielding. In this case, the PCB 42 is held between a convex portion 43a protruding from an inner surface of the shield casing 43 and an upwardly extending side member 46a of the bottom plate 46. The bottom plate 46 is attached to the shield casing 43 by soldering.

The reception bandpass filter 5 is formed as a unitary block and is shielded in like manner to the transmission bandpass filter 4, again as shown in Figures 3 and 4, the input and output terminals of the filter 5 being designated 54 and 55, respectively.

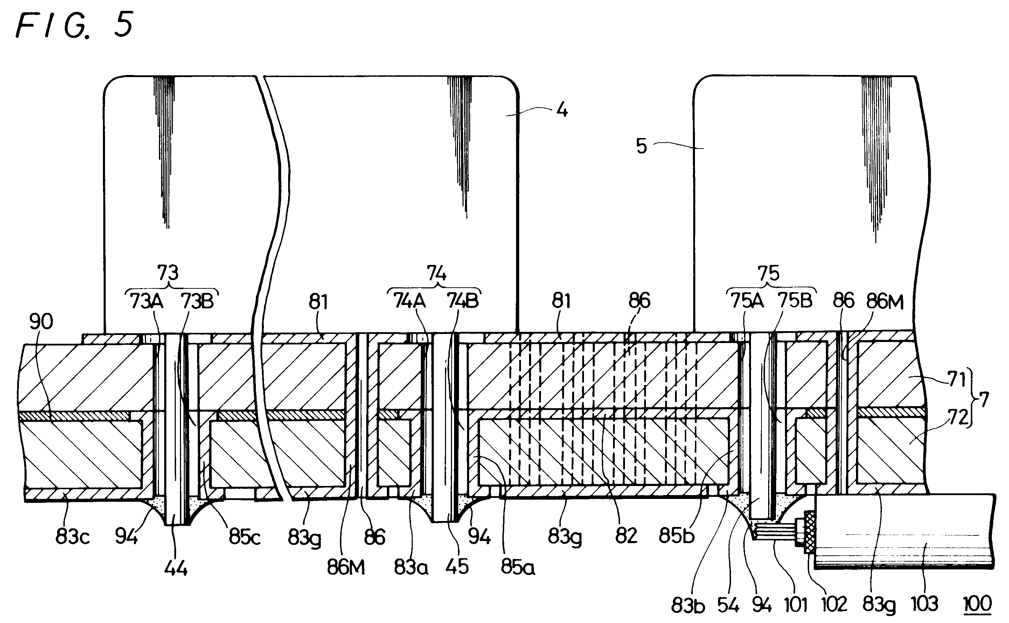

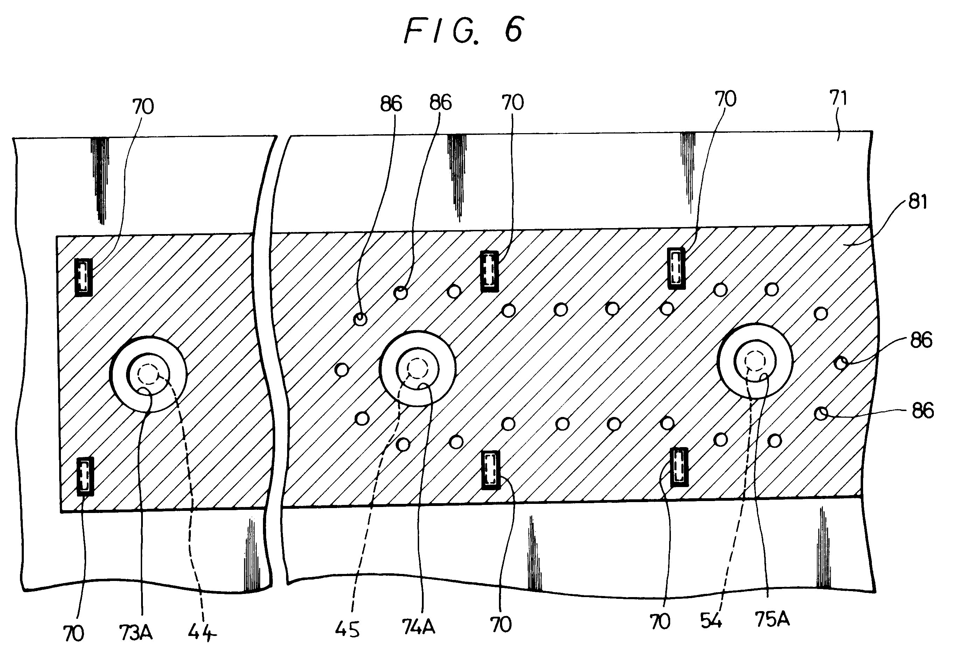

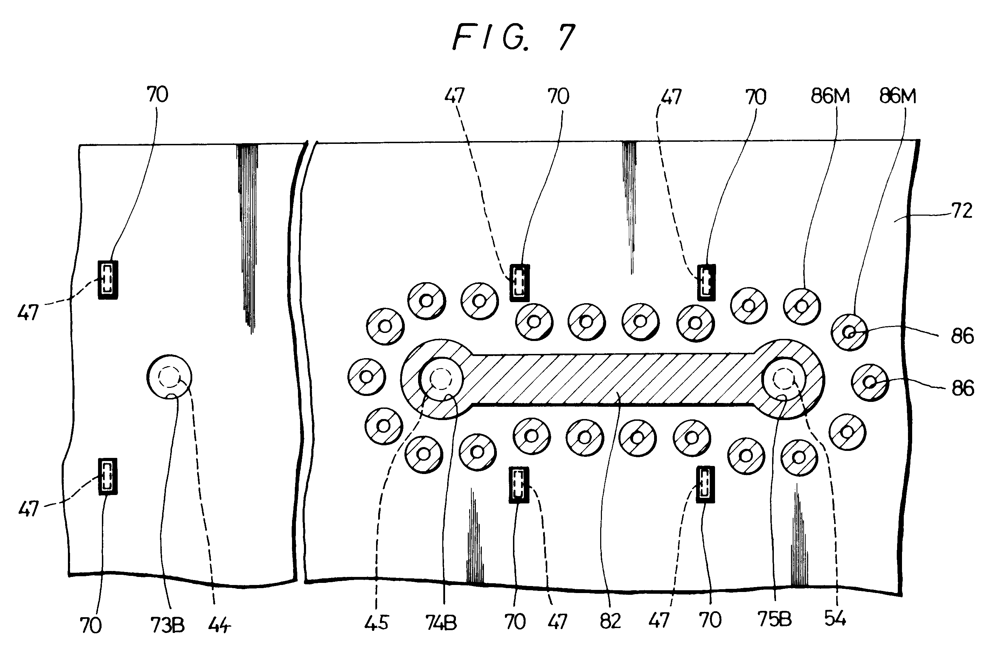

As shown in Figure 5, the filters 4 and 5 are mounted on a printed circuit board (PCB) 7 in series such that the output terminal 45 of the filter 4 and the input terminal 54 of the filter 5 protrude from the same surface of the PCB 7.

Further, in the embodiment of Figure 5, the PCB 7 is formed as a multi-layer assembly. More specifically, the PCB 7 comprises upper and lower substrates 71 and 72 that are insulating substrates made of, for example, a glass epoxy resin, the substrates 71 and 72 being subsequently laminated to form the multi-layer PCB 7.

As shown in Figure 5, through-holes 73, 74, and 75 are formed through the substrates 71 and 72 so as to receive therein the input and output terminals 44, 45 and 54. The output terminal 55 of the filter 5 and a through-hole which is formed in the substrates 71 and 72 and into which the output terminal 55 is inserted are not shown in Figures 3 to 8, but the through-hole is similar to the through-hole 73 for the filter 4 shown in Figure 5. Through-holes 73A, 74A and 75A formed through the upper substrate 71 and through-holes 73B, 74B and 75B formed through the lower substrate 72 combine to form the through-holes 73, 74, and 75.

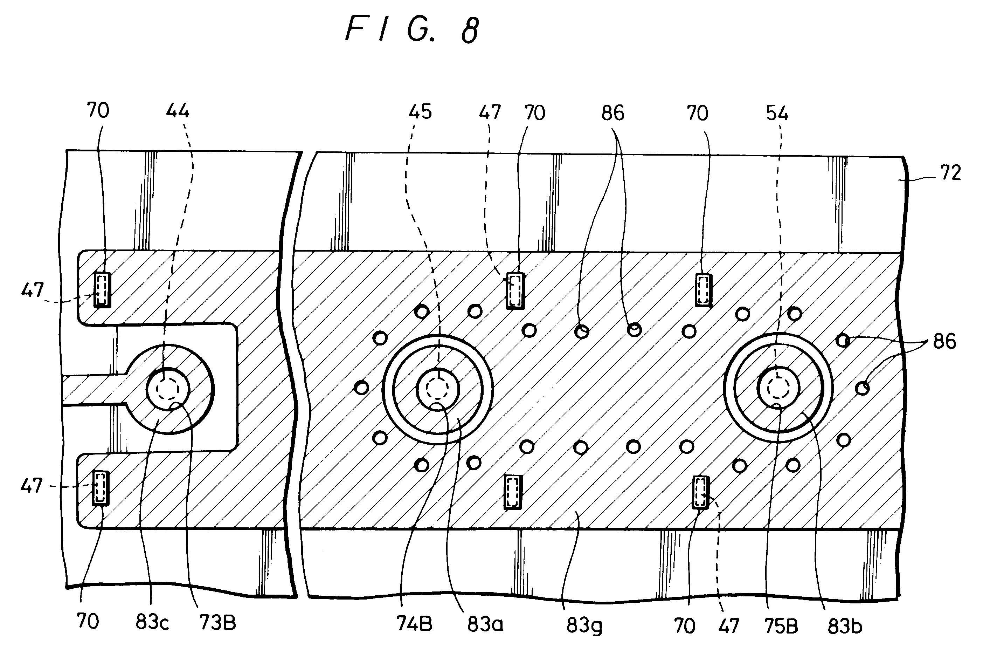

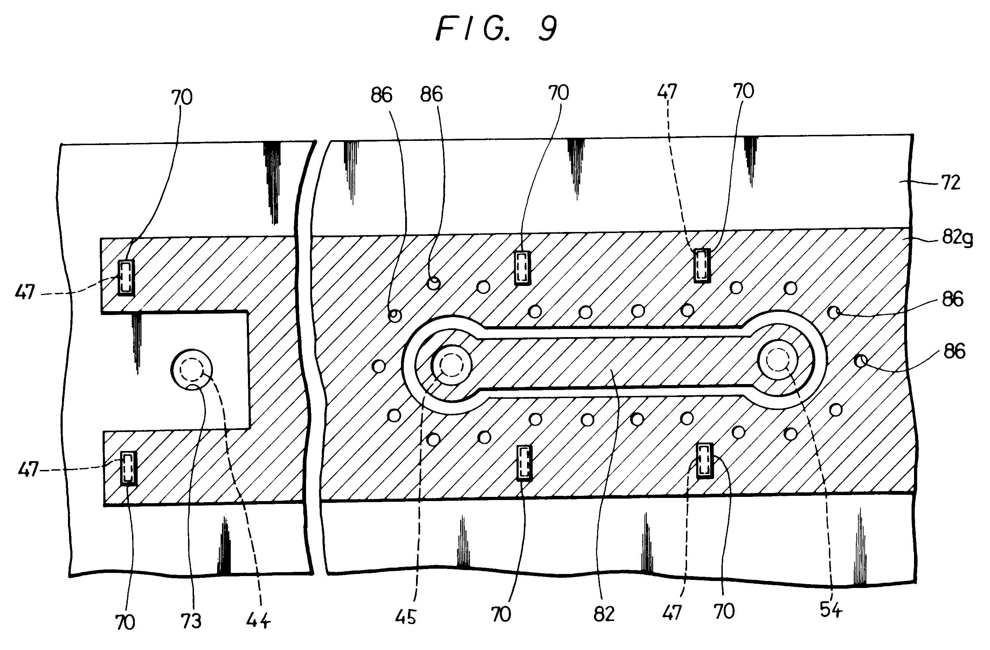

The upper substrate 71 has a conductive pattern formed on the top surface thereof, whereas the lower substrate 72 is formed as a double-sided PCB having conductive patterns formed on the top and bottom surfaces thereof. More specifically, a ground conductive pattern 81 is formed on the mounting surface of the upper substrate 71, as shown in Figure 6, and a connection conductive pattern 82 is formed on the top surface of the lower substrate 72, as shown in Figure 7. Further, soldering round conductive pattern portions 83a, 83b, and 83c and a ground conductive pattern 83g are formed on the lower surface of the lower substrate 72, as shown in Figure 8.

In this case, the ground conductive pattern 81 is formed on the mounting surface of the upper substrate 71 at a position opposing the filters 4 and 5 when mounted. The mounting surface is formed large enough to accommodate the through-holes 73A, 74A and 75A, so that portions surrounding the through-holes 73A, 74A and 75A are also grounded.

The connection conductive pattern 82 is so formed on the top surface of the lower substrate 72 as to connect the surrounding portions of the through-holes 74B and 75B, as shown in Figure 7.

Furthermore, as shown in Figure 8, the conductive pattern on the bottom surface of the lower substrate 72 is divided to provide the soldering round conductive pattern portions 83a and 83b around the through-holes 74B and 75B, the soldering round conductive pattern portion 83c around the through-hole 73B, and the ground conductive pattern 83g covering much of the remaining lower surface of the lower substrate 72 (but not connected to the soldering round conductive pattern portions 83a, 83b and 83c). The soldering round conductive pattern portions 83a and 83b are electrically connected together via through-hole plating layers 85a and 85b formed on the internal walls of the through-holes 74B and 75B, as shown in Figure 5. The soldering round conductive pattern portion 83c is electrically connected to a through-hole plating layer 85c formed on the inner wall of the through-hole 73B. The ground conductive pattern 83g is formed on the lower surface of the lower substrate 72 at a position opposing at least the connection conductive pattern 82 on the upper surface of the lower substrate 72 and is subsequently grounded.

As shown in Figure 6, insertion apertures 70 and apertures 86 are formed by suitable means, such as the punching or drilling using a ball mill, when the upper and lower substrates 71 and 72 are bonded together by an adhesive agent 90, as shown in Figure 5. The insertion apertures 70 receive therein the leg portions 47 of the shield casings 43 of the filters 4 and 5. The plurality of apertures 86 surround the connection conductive pattern 82 and, after drilling is finished, portions other than the through-holes 86 are masked and the through-holes 86 are then plated, thereby to form plated layers 86M on the interior surfaces of all of the through-holes 86. Further, as shown in Figure 7, the plurality of through-holes 86 are arranged so as to surround completely the connection conductive pattern 82 with a predetermined spacing between them and at a predetermined distance from the connection conductive pattern 82. The through-holes 86 and plated layers 86M are formed to electrically connect the ground conductive patterns 81 and 83g.

The filters 4 and 5 are mounted on the mounting surface of the substrate 71 so that the input and output terminals 44 and 45 of the filter 4 and the input terminal 54 of the filter 5 are inserted into the through-holes 73, 74, and 75, respectively. Further, the terminals 44, 45, and 54 are soldered to the soldering round pattern portions 83c, 83a, and 83b by solder 94. Simultaneously, the leg portions 47 of the shield casings 43 of the filters 4 and 5 are soldered to the ground conductive pattern 83g by solder 94. The output terminal 55 of the filter 5, not shown in Figure 5, is also soldered to a soldering round pattern portion provided at a position symmetrical to that of the pattern portion 83c.

As shown in Figure 5, a central conductor 101 of a coaxial cable 100, which is connected to the aerial 3, is soldered to the terminal 54 and the soldering round pattern portion 83b with solder 94. A shield conductor or wire 102 of the coaxial cable 100 is formed as a woven braid or mesh and the cable 100 has an outer insulating sheath 103.

According to the above-described embodiment, the transmission signal Su from the filter 4 is supplied to the aerial 3 through a signal path constituted by the internal circuitry of the filter 4, the terminal 45, the solder 94, the soldering round pattern portion 83a, the through-hole plating layer 85a, the connection conductive pattern 82, the through-hole layer plating 85b, the soldering round pattern portion 83b, the solder 94, the coaxial cable 100 and the aerial 3, in that order, and is then transmitted from the aerial 3.

The received signal Sd from the aerial 3 is supplied to the filter 5 through a signal path constituted by the aerial 3, the coaxial cable 100, the solder 94, the terminal 54 and the filter 5, in that order.

The transmission of the signal Su and the reception of the signal Sd are carried out as described above. It can be seen that the connection conductive pattern 82, which forms part of the signal path of the signal Su, is sandwiched between the ground conductive patterns 81 and 83g and is shielded from leakage in the planes of the substrates by the plurality of through-hole layers 86M, so as to act as a shielded strip path or coaxial cable, thereby preventing the signal Su from leaking.

A filter apparatus according to a second embodiment of the invention, in which the shielding effect is made more powerful, will now be described with reference to Figure 9. In order to increase the shielding effect, a ground conductive pattern 82g encircling the connection conductive pattern 82 with a predetermined spacing between them is provided on the top surface of the lower substrate 72, as shown in Figure 9. A plurality of through-hole plated layers, shown at 86M in Figure 5, are formed in the ground conductive pattern 82g, whereby the ground conductive pattern 82g is connected to the ground conductive patterns 81 and 83g.

It should be appreciated that, notwithstanding the foregoing, in both the first and second embodiments of the invention the shielding effect of the connection conductive pattern 82 is satisfactory for most applications, without providing the through-holes 86 and the throughhole plated layers 86M.

It will be seen that, in the above-described embodiments, the filters 4 and 5 and the signal paths for connecting the filters 4 and 5 and the aerial 3 are independently shielded, whereby isolation between the respective input and output terminals can be improved. Also, since the filters 4 and 5 and the signal paths are independently shielded, the filters 4 and 5 and the signal paths can be freely designed, that is laid out in any desired fashion, when designing the PCB 7. Thus, the filters 4 and 5 can be mounted on the PCB 7 together with components of the transmitting circuit 1 and the receiving circuit 2.

The filters 4 and 5 are not necessarily located in tandem, that is aligned in the same direction, as described above. The filters 4 and 5 may for example be aligned so that they are at right angles (90 degrees) to each other, depending upon the size and/or shape of the PCB 7. In that case, the ground conductive patterns 81 and 83g and the connection conductive pattern 82 are curved through 90 degrees, whereby the filters 4 and 5 and the signal paths can be positioned with greater freedom.

By selecting a proper spacing between the through-hole plated layers 86M and the conductive pattern 82, or selecting a proper width of the conductive pattern 82, it is possible to perform impedance matching between the filters 4, 5 and the coaxial cable 100. Thus, the signals Su and Sd can be transmitted properly and transmission and reflection losses can be avoided.

Further, as shown in Figure 10, the filters 4 and 5 can be mounted directly on the PCB 7 and the expensive coaxial connectors 63, 64 and 65 are not needed, thereby considerably reducing the cost of the filter apparatus.

Since, as explained above, the connection conductive pattern 82, which forms part of the signal path of the signal Su, is shielded by the conductive patterns 81 and 83g formed on the mounting surface and the soldered surface, respectively, and the through-hole plated layers 86M act as the shielded strip path, it is possible to prevent leakage of the signal Su.

Further, since the filters 4 and 5 and the signal path layers 86M act as the shielded strip path, it is possible to prevent leakage of the signal Su.

Also, since the filters 4 and 5 and the signal paths for connecting the filters 4, 5 and the aerial 3 are independently shielded, isolation between the input and output terminals is improved. Further, since the filters 4 and 5 and the signal paths are independently shielded, the filters 4 and 5 and the signal paths can be designed with greater freedom. In addition, the filters 4 and 5 can be mounted on the PCB 7 together with the components of the transmitting circuit 1 and the receiving circuit 2, and they can be positioned on the PCB with greater freedom.

## Claims

1. A filter apparatus comprising:
a multi-layer printed circuit board (7) formed of first and second insulating substrates (71, 72);
a filter (4) mounted on the printed circuit board (7), the filter having input and output terminals (44, 45) which extend through and protrude from the printed circuit board;
a connection conductive pattern (82) formed on the second insulating substrate (72) on an inner surface thereof facing the first insulating substrate (71); and
a plurality of conductive layers (81, 83g) formed on outer surfaces of the first and second insulating substrates (71, 72) such that a first (81) of said conductive layers (81, 83g) is positioned on one side of the connection conductive pattern (82) and a second (83g) of said conductive layers (81, 83g) is positioned on the other side of the connection conductive pattern (82), at least one (45) of the input and output terminals (44, 45) of the filter (4) being connected to the connection conductive pattern (82) and said plurality of conductive layers (81, 83g) being grounded so as thereby to shield the connection conductive pattern (82).

2. A filter apparatus according to claim 1, comprising an encircling conductive pattern formed so as to encircle the connection conductive pattern (82), the encircling conductive pattern being formed of a plurality of through-holes (86) in the multi-layer printed circuit board (7), the through-holes (86) each having a plated conductive layer (86M).

3. A filter apparatus according to claim 2, comprising a ground conductive layer (82g) formed so as to encircle the connection conductive pattern (82), the through-holes (86) protruding through the ground conductive layer (82g) and the ground conductive layer (82g) being grounded.

4. A filter apparatus according to any one of the preceding claims, comprising a shielding case (43) accommodating the filter (4) mounted on the printed circuit board (7).

5. A filter apparatus according to any one of the preceding claims, wherein the input and output terminals (44, 54) protrude in the same direction from the multi-layer printed circuit board (7).

6. A filter apparatus comprising:
a multi-layer printed circuit board (7) formed of first and second insulating substrates (71, 72);
a filter (4) mounted on the printed circuit board (7), the filter having input and output terminals (44, 45) which extend through and protrude from the printed circuit board;
a connection conductive pattern (82) formed on the second insulating substrate (72) on an inner surface thereof facing the first insulating substrate (71);
a plurality of conductive layers (81, 83g) formed on outer surfaces of the first and second insulating substrates (71, 72) such that a first (81) of said conductive layers (81, 83g) is positioned on one side of the connection conductive pattern (82) and a second (83g) of said conductive layers (81, 83g) is positioned on the other side of the connection conductive pattern (82); and
a plurality of plated conductive through-holes (86) formed through the first and second substrates (71, 72) and said plurality of conductive layers (81, 83g) so as to encircle at least one (44) of the input and output terminals (44, 45), so as to connect said conductive layers (81, 83g), and so as to encircle said connection conductive pattern (82), said conductive layers (81, 83g) connected by said through-holes (86) being grounded and the connective conductive pattern (82) being shielded by said conductive layers (81, 83g) and the through-holes (86).

7. A filter apparatus according to claim 6, wherein the plurality of through-holes (86) are surrounded by a plating layer (86M) so that said one (44) of the input and output terminals (44, 45) encircled by the through-holes (86) is shielded.

8. A filter apparatus according to claim 7, comprising a ground conductive layer (82g) formed so as to encircle the connection conductive pattern (82), the through-holes protruding through the ground conductive layer (82g) and the ground conductive layer (82g) being grounded.

9. A filter apparatus according to any one of claims 6 to 8, comprising a shielding case (43) accommodating the filter.

10. A filter apparatus according to any one of claims 6 to 9, wherein the input and output terminals (44, 45) protrude in the same direction from the printed circuit board (7).

## Patentansprüche

1. Filtervorrichtung umfassend:
eine gedruckte Vielschichtplatine (7), die aus einem ersten und einem zweiten isolierenden Substrat (71, 72) gebildet ist;
einen auf der gedruckten Schaltplatine (7) befestigten Filter (4), wobei der Filter Eingangs- und Ausgangsanschlüsse (44, 45) aufweist, die sich durch die gedruckte Schaltplatine erstrecken und über diese hervorragen;
ein Anschlußleitungsmuster (82), das auf dem zweiten isolierenden Substrat (72) auf einer inneren Oberfläche desselben gebildet ist, die dem ersten isolierenden Substrat (71) gegenüberliegt; und
eine Mehrzahl leitfähiger Schichten (81, 83g), die auf den äußeren Oberflächen des ersten und des zweiten isolierenden Substrates (71, 72) so ausgebildet sind, daß eine erste (81) der leitfähigen Schichten (81, 83g) auf einer Seite des Anschlußleitungsmusters (82) angeordnet ist, und eine zweite (83g) der leitfähigen Schichten (81, 83g) auf der anderen Seite des Anschlußleitungsmusters (82) angeordnet ist, wobei wenigstens einer (45) der Eingangs- und Ausgangsanschlüsse (44, 45) des Filters (4) mit dem Anschlußleitungsmuster (82) verbunden ist, und die Mehrzahl der leitfähigen Schichten (81, 83g) geerdet sind, so daß sie das Anschlußleitungsmuster (81, 82) abschirmen.

2. Filtervorrichtung nach Anspruch 1, umfassend ein umgebendes leitfähiges Muster, das so ausgebildet ist, daß es das Anschlußleitungsmuster (82) umgibt, wobei das umgebende Leitungsmuster durch eine Mehrzahl von Durchgangsbohrungen (86) in der gedruckten Vielschichtschaltplatine (7) gebildet ist, wobei jede der Durchgangsbohrungen (86) eine leitfähige Auskleidungsschicht (86m) aufweist.

3. Filtervorrichtung nach Anspruch 2, umfassend eine leitfähige Erdungsschicht (82g), die so ausgebildet ist, daß sie das Anschlußleitungsmuster (82) umgibt, wobei Durchgangsbohrungen (86) sich durch die leitfähige Erdungsschicht (82g) erstrecken und die leitfähige Erdungsschicht (82g) geerdet ist.

4. Filtervorrichtung nach einem der vorhergehenden Ansprüche, umfassend ein Abschirmungsgehäuse (43), in dem der auf der gedruckten Schaltplatine (7) befestigte Filter (4) untergebracht ist.

5. Filtervorrichtung nach einem der vorhergehenden Ansprüche, wobei Eingangs- und Ausgangsanschlüsse (44, 45) in derselben Richtung von der gedruckten Vielschichtschaltungsplatine (7) hervorstehen.

6. Filtervorrichtung umfassend:
eine gedruckte Vielschichtschaltplatine (7), die aus einem ersten und einem zweiten isolierenden Substrat (71, 72) gebildet ist;
ein auf der gedruckten Schaltplatine (7) befestigter Filter (4), wobei der Filter Eingangs- und Ausgangsanschlüsse (44, 45) aufweist, die sich durch die gedruckte Schaltplatine erstrecken und von dieser hervorstehen;
ein Anschlußleitungsmuster (82), das auf dem zweiten isolierenden Substrat (72) auf einer inneren Oberfläche desselben gebildet ist, die dem ersten isolierenden Substrat (71) gegenüberliegt;
eine Mehrzahl leitfähiger Schichten (81, 83g), die auf äußeren Oberflächen des ersten und des zweiten isolierenden Substrates (71, 72) so ausgebildet ist, daß eine erste (81) der leitfähigen Schichten (81, 83g) auf einer Seite des Anschlußleitungsmusters (82) angeordnet ist und eine zweite (83g) der leitfähigen Schichten (81, 83g) auf der anderen Seite des Anschlußleitungsmusters (82) angeordnet ist; und
eine Mehrzahl von ausgekleideten leitfähigen Durchgangsbohrungen (86), die durch das erste und das zweite Substrat (71, 72) und die Mehrzahl der leitfähigen Schichten (81, 83) gebildet sind, so daß sie wenigstens einen (44) der Eingangs- und Ausgangsanschlüsse (44, 45) umgeben, so daß sie die leitfähigen Schichten (81, 83g) verbinden, und wobei sie das Anschlußleitungsmuster (82) umgeben, wobei die durch die Durchgangsbohrungen (86) verbundenen leitfähigen Schichten (81, 83g) geerdet sind und das Anschlußleitungsmuster (82) durch die leitfähigen Schichten (81, 83g) und die Durchgangsbohrung (86) abgeschirmt sind.

7. Filtervorrichtung nach Anspruch 6, wobei die Mehrzahl der Durchgangsbohrungen (86) durch eine Auskleidungsschicht (86M) umgeben sind, so daß einer (44) der Eingangs- und Ausgangsanschlüsse (44, 45), der durch die Durchgangsbohrungen (86) umgeben ist, abgeschirmt ist.

8. Filtervorrichtung nach Anspruch 7, umfassend eine leitfähige Erdungsschicht (82g), die so ausgebildet ist, daß sie das Anschlußleitungsmuster (82) umgibt, wobei die Durchgangsbohrungen sich durch die leitfähige Erdungsschicht (82g) erstrecken und die leitfähige Erdungsschicht (82g) geerdet ist.

9. Filtervorrichtung nach einem der vorhergehenden Ansprüche 6 bis 8 umfassend ein Abschirmungsgehäuse (43) zur Unterbringung des Filters.

10. Filtervorrichtung nach einem der vorhergehenden Ansprüche 6 bis 9, wobei die Eingangs- und Ausgangsanschlüsse (44, 45) in derselben Richtung von der gedruckten Schaltplatine (7) hervorragen.

## Revendications

1. Appareil de filtrage comprenant :
- une carte à circuits imprimés multicouche (7) formée d'un premier et d'un second substrat isolant (71, 72) ;
- un filtre (4) monté sur la carte à circuits imprimés (7), le filtre ayant des bornes d'entrée et de sortie (44, 45) qui s'étendent à travers la carte à circuits imprimés et dépassent de celle-ci ;
- un motif conducteur de connexion (82) formé sur le second substrat isolant (72) sur une surface intérieure de celui-ci et faisant face au premier substrat isolant (71) ; et
- une pluralité de couches conductrices (81, 83g) formées sur les surfaces extérieures du premier et du second substrat isolant (71, 72) de telle sorte qu'une première couche (81) desdites couches conductrices (81, 83g) est positionnée sur un côté du motif conducteur de connexion (82) et une seconde couche (83g) desdites couches conductrices (81, 83g) est positionnée sur l'autre côté du motif conducteur de connexion (82), au moins une borne (45) parmi les bornes d'entrée et de sortie (44, 45) du filtre (4) étant connectée au motif conducteur de connexion (82) et ladite pluralité de couches conductrices (81, 83g) étant mises à la terre de manière à constituer un écran pour le motif conducteur de connexion (82).

2. Appareil de filtrage selon la revendication 1, comprenant un motif conducteur d'encerclement formé de manière à encercler le motif conducteur de connexion (82), le motif conducteur d'encerclement étant formé d'une pluralité de trous traversant (86) dans la carte à circuits imprimés multicouche (7), les trous traversants (86) ayant chacun une couche de revêtement conductrice (86M).

3. Appareil de filtrage selon la revendication 2, comprenant une couche conductrice de mise à la terre (82g) formée de manière à encercler le motif conducteur de connexion (82), les trous traversants (86) faisant saillie à travers la couche conductrice de mise à la terre (82g) et la couche conductrice de mise à la terre (82g) étant mise à la terre.

4. Appareil de filtrage selon l'une quelconque des revendications précédentes, comprenant un boîtier-écran (83) qui abrite le filtre (4) monté sur la carte à circuits imprimés (7).

5. Appareil de filtrage selon l'une quelconque des revendications précédentes, dans lequel les bornes d'entrée et de sortie (44, 45) dépassent dans la même direction depuis la carte à circuits imprimés multicouches (7).

6. Appareil de filtrage comprenant :
- une carte à circuits imprimés multicouche (7) formée d'un premier et d'un second substrat isolant (71, 72) ;
- un filtre (4) monté sur la carte à circuits imprimés (7), le filtre ayant des bornes d'entrée et de sortie (44, 45) qui s'étendent à travers la carte à circuits imprimés et dépassent de celle-ci ;
- un motif conducteur de connexion (82) formé sur le second substrat isolant (72) et sur une surface intérieure de celui-ci qui fait face au premier substrat isolant (71) ; et
- une pluralité de couches conductrices (81, 83g) formées sur les surfaces extérieures du premier et du second substrat isolant (71, 72) de telle sorte qu'une première couche (81) desdites couches conductrices (81, 83g) est positionnée sur un côté du motif conducteur de connexion (82), et une seconde couche (83g) desdites couches conductrices (81, 83g) est positionnée sur l'autre côté du motif conducteur de connexion (82) ; et
- une pluralité de trous traversants avec plaquage conducteur (86) formés à travers le premier et le second substrat (71, 72) et ladite pluralité de couches conductrices (81, 83g) afin d'encercler au moins une borne (44) parmi les bornes d'entrée et de sortie (44, 45) de manière à connecter lesdites couches conductrices (81, 83g), et à encercler ledit motif conducteur de connexion (82), lesdites couches conductrices (81, 83g) reliées par lesdits trous traversants (86) étant mises à la terre et le motif conducteur de connexion (82) étant protégé par lesdites couches conductrices (81, 83g) et les trous traversants (86).

7. Appareil de filtrage selon la revendication 6, dans lequel la pluralité de trous traversants (86) sont entourés par une couche de plaquage (86M) de telle sorte que ladite borne (44) parmi les bornes d'entrée et de sortie (44, 45) encerclée par les trous traversants (86) est protégée.

8. Appareil de filtrage selon la revendication 7, comprenant une couche conductrice de mise à la terre (82g) formée de manière à encercler le motif conducteur de connexion (82), les trous traversant dépassant à travers la couche conductrice de mise à la terre (82g) et la couche conductrice de mise à la terre (82g) étant mise à la terre.

9. Appareil de filtrage selon l'une quelconque des revendications 6 à 8, comprenant un boîtier-écran (43) recevant le filtre.

10. Appareil de filtrage selon l'une quelconque des revendications 6 à 9, dans lequel les bornes d'entrée et de sortie (44, 45) dépassent dans la même direction depuis la carte à circuits imprimés (7).
